# EUROPEAN PATENT APPLICATION

(11) **EP 4 839 027 A1**
(43) Date of publication of application: **11.11.2026**
(21) Application number: 26169256.0
(22) Date of filing: 30.03.2026
(51) Int. Cl.: H05K 1/02, H05K 3/00, H05K 7/20

(54) **SYSTEMS AND METHODS OF FORMED SHEET METAL COMPONENTS WITH COIN FEATURES FOR THROUGH-BOARD HEAT SPREADING**

(30) Priority: 07.05.2025 US 202519200817
(71) Applicant: GE Aviation Systems Limited, Bishops Cleeve Cheltenham Gloucestershire GL52 8SF (GB)
(72) Inventor: SMITH, Michael James, Cheltenham, GL52 8SF (GB)
(74) Representative: Openshaw & Co.

(57) **Abstract**

An apparatus includes a printed circuit board (106) having at least one aperture (108) or cutout; and a formed coin plate (102) having at least one raised region (104). The at least one raised region (104) includes a hollow interior, the formed coin plate (102) is secured to the printed circuit board (106), and the at least one raised region (104) extends through the at least one aperture (108) or cutout. A surface of the at least one raised region (104) is configured to contact a surface of a heat-generating component (114), when the heat-generating component (114) is mounted on the printed circuit board (106), to provide a heat transfer path from the surface of the heat-generating component (114) through the formed coin plate (102) to the hollow interior of the at least one raised region (104).

## Description

### FIELD OF THE DISCLOSURE

The present subject matter relates generally to the fabrication of printed circuit board heat dispensing features.

### BACKGROUND

Printed circuit boards (PCBs) include heat producing components mounted on the PCBs. Heat from the heat producing components can cause damage to the PCBs or to the heat producing components if the heat reaches at least a threshold temperature. Furthermore, excessive heat may reduce performance. Therefore, it can be beneficial to include ways of dispersing the heat to prevent damage. Current heat dispensing features for PCBs include coins, conformal vapor chambers, heat exchangers, and uniform thermal layers. Generally, current heat dispensing features require an additional thermal interface between the heat source and the heat dispensing features which increases the thermal path of the heat and complicates assembly while often also increasing cost.

### BRIEF DESCRIPTION OF THE DRAWINGS

A full and enabling disclosure of the present disclosure, including the best mode thereof, directed to one of ordinary skill in the art, is set forth in the specification, which makes reference to the appended figures.
FIG. 1 illustrates a perspective view in accordance with some embodiments of the present disclosure.
FIG. 2 illustrates a perspective view in accordance with some embodiments of the present disclosure
FIG. 3 illustrates a bottom perspective view in accordance with some embodiments of the present disclosure.
FIG. 4 illustrates a sectional view in accordance with some embodiments of the present disclosure.
FIG. 5 illustrates a sectional view in accordance with some embodiments of the present disclosure.
FIG. 6 illustrates a perspective view in accordance with some embodiments of the present disclosure.
FIG. 7 illustrates a sectional view in accordance with some embodiments of the present disclosure.
FIG. 8 illustrates a flowchart in accordance with some embodiments of the present disclosure.

### DETAILED DESCRIPTION

Reference now will be made in detail to embodiments of the present disclosure, one or more examples of which are illustrated in the drawings. Each example is provided by way of explanation of the present disclosure, not limitation of the disclosure. In fact, it will be apparent to those skilled in the art that various modifications and variations can be made in the present disclosure without departing from the scope of the disclosure. For instance, features illustrated or described as part of one embodiment can be used with another embodiment to yield a still further embodiment. Thus, it is intended that the present disclosure covers such modifications and variations as come within the scope of the appended claims and their equivalents.

As used herein, the terms "first," "second," "third," etc. may be used interchangeably to distinguish one component from another and are not intended to signify location or importance of the individual components. The terms "coupled," "fixed," "attached to," and the like refer to both direct coupling, fixing, or attaching, as well as indirect coupling, fixing, or attaching through one or more intermediate components or features, unless otherwise specified herein. The singular forms "a," "an," and "the" include plural referents unless the context clearly dictates otherwise. Further, the phrase "based on" is intended to mean "based, at least in part, on" unless explicitly stated otherwise. No element, act, or instruction in the present application should be construed as critical or essential to the embodiments described herein unless explicitly described as such.

Approximating language, as used herein throughout the specification and claims, may be applied to modify any quantitative representation that could permissibly vary without resulting in a change in the basic function to which it is related. Accordingly, a value modified by a term or terms, such as "about," "approximately," "almost," and "substantially" are not to be limited to the precise value specified. In some instances, the approximating language may correspond to the precision of an instrument for measuring the value. For example, the approximating language may refer to being within a 1, 2, 4, 10, 15, or 20 percent margin. These approximating margins may apply to a single value, either or both endpoints defining numerical ranges, and/or the margin for ranges between endpoints. Here and throughout the specification and claims, range limitations are combined and interchanged, such ranges are identified and include all the sub-ranges contained therein unless context or language indicates otherwise. For example, all ranges disclosed herein are inclusive of the endpoints, and the endpoints are independently combinable with each other.

It is additionally noted that the term "substantially" is also utilized herein to represent an inherent degree of uncertainty that may be attributed to any quantitative comparison, value, measurement, or other representation. The term "substantially" is also utilized herein to represent the degree by which a quantitative representation may vary from a stated reference without resulting in a change in the basic function of the subject matter at issue.

Systems and methods described herein include formed sheet components with coin features for through-board heat spreading and methods for forming the same. A printed circuit board (PCB) assembly includes a PCB secured to a component formed from a sheet of material. The formed component is referred to herein as a "formed coin plate" (FCP). A formed coin plate includes one or more raised regions that function as heat transfer coins with respect to components mounted on the PCB. The PCB assembly may be formed with a top side of the FCP coupled to a bottom side of the PCB, with electrical components mounted on a top side of the PCB with bottoms of the electrical components in contact with the raised regions of the formed coin plate through apertures or cutouts in the PCB.

A component, such as, for example, an electrical component mounted on the PCB may include an electrical component that generates heat as a result of, for example, electrical resistance to electrical current being converted into heat energy. Thus, the component may generate heat as a result of the operation of the component and is referred herein as a "heat-generating component." The generated heat may be undesirable. Such generated heat may reduce the efficiency of, and/or potentially damage, the component and/or other components on the PCB. The printed PCB assembly described herein improves thermal conduction through the PCB, as well as in-plane across the PCB, to reduce heat hot spots in the PCB assembly and reduce thermal resistance between sources of heat in the PCB assembly and the ambient cooling environment.

Furthermore, the PCB assembly described herein may reduce the costs of heat transfer management. For example, the formed coin plate may be formed as a single piece with multiple raised regions, or as multiple pieces with each piece including multiple raised regions, and secured to the PCB in a single step, or in fewer steps, as opposed to a manufacturing process that requires the attachment of individual coin elements to individual components on the PCB. Additionally, regions of the formed coin plate that are not directly in contact with components mounted on the PCB may be in contact with the PCB and contribute to heat transfer away from the PCB. Therefore, the formed coin plate may enable use of a thinner PCB, and/or fewer layers in the construction of the PCB, when the thermal conduction requirements of the PCB are reduced by the presence of the formed coin plate.

In some aspects, an apparatus may include a printed circuit board having at least one aperture or cutout and a formed coin plate having at least one raised region that includes a hollow interior. The formed coin plate may be secured to the printed circuit board and the at least one raised region may extend through the at least one aperture or cutout. An aperture may be located away from an edge of the printed circuit board. A cutout may be located on an edge of the printed circuit board. A surface of the at least one raised region may be configured to contact a surface of a heat-generating component, when the heat-generating component is mounted on the printed circuit board, to provide a heat transfer path from the surface of the heat-generating component through the formed coin plate to the hollow interior of the at least one raised region. The formed coin plate may include multiple raised regions and the printed circuit board may include multiple apertures or cutouts, such that a particular raised region extends through a particular aperture or cutout.

The formed coin plate may include sheet metal, such as, for example, aluminum, copper, titanium, and/or another type of metal. The raised regions of the formed coin plate may include features stamped from the sheet metal. In some implementations, the raised regions may be substantially planar with respect to the heat-generating components, such as when the heat-generating components are surface-mounted on the PCB. For example, the surfaces of the raised regions may be parallel with respect to a surface of the printed circuit board. In other implementations, the raised regions may not necessarily be planar, such as, for example, when the heat-generating components are not necessarily surface-mounted on the PCB (e.g., through-hole mounted components, components mounted to other assemblies that are electrically coupled to the PCB, etc.). A height of a raised region extending through an aperture or cutout may be based on a height of the surface of a heat-generating component from a surface of the printed circuit board, when the heat-generating component is mounted on the printed circuit board. In some implementations, the top surfaces of the raised regions may be in the same plane as the top surface of the PCB. In other implementations, such as when the bottom surfaces of the heat-generating components are some distance above the top surface of the PCB, the top surfaces of the raised regions may be higher than the top surface of the PCB.

In some implementations, the formed coin plate may include a dielectric layer secured to a first surface of the formed coined plate that is opposite a second surface of the formed coin plate that is in contact with the printed circuit board. The dielectric layer may prevent direct electrical conductivity between the formed coin plate and a cooling fluid used to conduct and/or convect heat away from the components mounted on the PCB.

In some implementations, the formed coin plate may further include heat exchanging features extending away from a first surface of the formed coin plate that is opposite a second surface of the formed coin plate contacting the printed circuit board. The heat exchanging features may include heat exchanging pins, heat exchanging fins, and/or other types of structures that increase the surface area of the first surface of the formed coin plate and thus increase the thermal conducting surfaces of the formed coin plate.

In some implementations, the formed coin plate may include a cooling fluid reservoir that is thermally coupled to the formed coin plate. The cooling fluid reservoir may include a chamber, a set of pipes, and/or another type of reservoir that includes a cooling fluid. The cooling fluid may be static or be circulated and may include a liquid cooling fluid or a gas cooling fluid. In some implementations, the cooling fluid may include a phase change working fluid that removes heat through the latent heat of vaporization.

In other aspects, a method may include creating at least one raised region in a sheet of material to form a coin plate, wherein the at least one raised region includes a hollow interior, creating at least one aperture or cutout in a printed circuit board, aligning the formed coin plate with the printed circuit board to extend the at least one raised region through the at least one aperture or cutout, wherein a surface of the at least one raised region is configured to contact a surface of a heat-generating component, when the heat-generating component is mounted on the printed circuit board, to provide a heat transfer path from the surface of the heat-generating component through the formed coin plate to the hollow interior of the at least one raised region, and securing the aligned formed coin plate to the printed circuit board.

Creating the at least one raised region in the sheet of material to form the coin plate may include creating multiple raised regions in the sheet of material, creating the at least one aperture or cutout in the printed circuit board may include creating multiple apertures or cutouts in the printed circuit board, and aligning the formed coin plate with the printed circuit board may include aligning the multiple raised regions with the multiple apertures or cutouts to extend particular ones of the raised regions through particular ones of the apertures or cutouts.

Forming the at least one raised region may include forming the at least one raised region as a stamped feature in the coin plate, forming the at least one raised region via an additive material manufacturing process, forming the at least one raised region via a subtractive material manufacturing process, and/or forming the at least one raised region using a different type of process.

In some implementations, the method may further include forming a dielectric layer on a first surface of the formed coined plate that is opposite a second surface contacting the printed circuit board. Furthermore, in some implementations, the method may further include forming heat exchanging features on the sheet of material extending away from a first surface of the sheet of material that is opposite a second surface of the sheet of material contacting the printed circuit board. Moreover, in some implementations, the method may further include forming a cooling fluid reservoir that is thermally coupled to the formed coin plate.

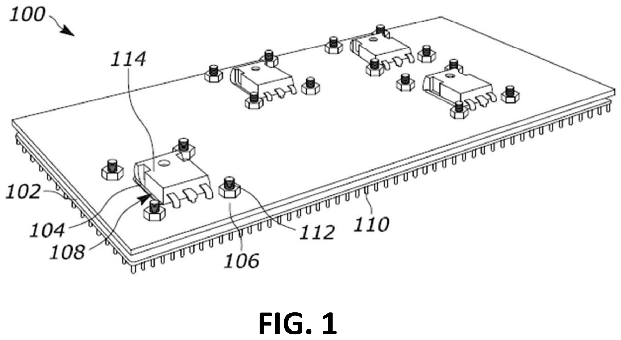

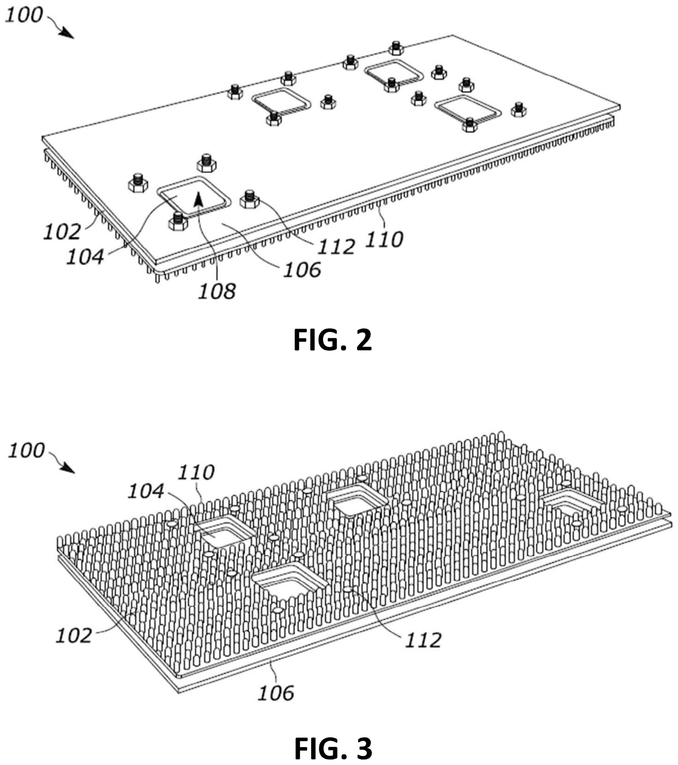

FIG. 1 shows a perspective view of an apparatus 100 in accordance with some embodiments. As shown in FIG. 1, the apparatus 100 may include a formed coin plate 102, a printed circuit board 106, coupling mechanisms 112 (referred to collectively as "coupling mechanisms 112" and individually as "coupling mechanism 112"), and heat-generating components 114 (referred to collectively as "heat-generating components 114" and individually as "heat-generating component 114"). FIG. 2 illustrates a perspective view of the apparatus 100 with the heat-generating components 114 removed. FIG. 3 illustrates a bottom perspective view of the apparatus 100.

The formed coin plate 102 may include a sheet of material with one or more raised regions 104. The raised region 104 may correspond to a heat-transfer coin with respect to the heat-generating component 114 that is in contact with the raised region 104. The PCB 106 may include one or more apertures 108. The formed coin plate 102 may be secured to the PCB 106 via the coupling mechanisms 112 such that the apertures 108 are aligned with the raised regions 104 and the raised regions 104 extend through the apertures 108 to contact surfaces of the heat-generating components 114 when the heat-generating components 114 are mounted on the PCB 106.

The raised regions 104 may include a hollow interior. The raised regions 104 may be substantially planar with respect to the heat-generating components 114, such that the bottom surface of the heat-generating components 114 are in contact with the top surfaces of the raised regions 104 and substantially parallel with respect to the top surface of the PCB 106. In other implementations, the top surfaces of the raised regions 104 may not necessarily be planar with the bottom surfaces of the heat-generating components 114 and/or the top surface of the PCB 106. The heights of the raised regions 104 extending through the apertures 108 may be based on the heights of bottom surfaces of corresponding heat-generating components 114 from the top surface of the PCB 106, when the heat-generating components 114 are mounted on the PCB 106, so that the bottom surfaces of the heat-generating components 114 are in contact with the top surface of the raised regions 104. The heat-generating components 114 are mounted to the printed circuit board 106. In some forms, the hollow-interior raised regions 104 disposed through the apertures 108 provide a heat transfer path from the heat-generating components 114 to the formed coin plate 102. The heat-generating components 114 may include any combination of power components, high-frequency components, resistors, diodes, transistors, integrated circuits, and/or other types of electrical or electronic components.

While FIGS. 1-3 and FIG. 6 illustrate four raised regions 104, four apertures 108, and/or four heat-generating components 114 in particular locations for illustrative purposes, in practice, the apparatus 100 may include a different number of, and/or differently arranged, raised regions 104, apertures 108, and/or heat-generating components 114. Additionally, while raised regions 104, apertures 108, and/or heat-generating components 114 are shown as having a square shape for illustrative purposes, in practice, raised regions 104, apertures 108, and/or heat-generating components 114 may include any shape, including, for example, shapes having curved surfaces. Furthermore, while FIGS. 1-3 and FIG. 6 illustrate apertures 108 for illustrative purposes, in practice, the apparatus 100 may include cutouts instead of, or in addition to, apertures 108. A cutout may be created on an edge of the printed circuit board 106 and not be surrounded on all sides by the printed circuit board 106.
Formed coin plate 102, in comparison to individual coins, reduces the cost of manufacture, improves reliability via improved thermal management of heat generating components, and/or enables reduced overall printed circuit board thickness/layer count. These improvements result from the reduced electrical and/or thermal conduction requirements of the printed circuit board 106 as a result of the formed coin plate 102. Use of individual coins may require increased costs and result in higher thermal resistance.

In some embodiments, the formed coin plate 102 (which may also be referred to herein as a cooling plate) is provided to dissipate heat. In some forms, the formed coin plate 102 includes sheet metal. Further, in some forms, the sheet metal includes aluminum. In some aspects, the sheet metal may include copper, titanium, steel, and/or any alternate suitable metal material. In some forms where the formed coin plate 102 includes aluminum and/or aluminum alloys, the formed coin plate 102 may have conductivity values between 120-200 W/mK. In some aspects, the side of the formed coin plate 102 which the hollow-interior raised regions 104 are not extending outwardly from may correspond to the external surface(s) of the apparatus 100 itself. Generally, the formed coin plate 102 dissipates heat to an ambient fluid (e.g., liquid or air). In embodiments where the ambient fluid is air, passive cooling without heatsink features has a heat transfer coefficient between 1-10 W/m²K, and active cooling, such as with a fan, forced liquid, thermoelectric coolers, and so forth, has a heat transfer coefficient between 20-50 W/m²K.

In some embodiments, the ambient fluid is a liquid. The liquid may be any suitable liquid for dispersing heat from the formed coin plate 102. In some forms, the bottom side (which is generally the side described above) of the formed coin plate 102 exposed to the liquid is coated in a dielectric material which prevents direct electrical conductivity to the liquid. In some forms, the formed coin plate 102 may be a barrier between the printed circuit board 106 and the liquid. Generally, active cooling with an ambient liquid has a heat transfer coefficient between 100-10,000 W/m²K and passive cooling with an ambient liquid has a heat transfer coefficient between 50-1000 W/m²K.

In some embodiments, the formed coin plate 102 includes a sheet formed by an additive material manufacturing process and/or a subtractive material manufacturing process. An additive material manufacturing process builds objects by adding layers of material on top of one another to create the object. Examples of an additive material manufacturing process include three-dimensional (3D) printing, sputtering, laser sintering, selective laser melting, binder jetting, etc. A subtractive material manufacturing process removes material from a solid object to create an object with a desired shape. Some examples of subtractive material manufacturing processes include milling, thread-cutting, selective etching, micromachining, and so forth. Any suitable manufacturing process to create the formed coin plate 102 with hollow-interior raised regions 104 may be used.

In some embodiments, the hollow-interior raised regions 104 are formed of the formed coin plate 102 and extend outwardly from the formed coin plate 102. In some aspects, the hollow-interior raised regions 104 are stamped features of the formed coin plate 102. In embodiments where the formed coin plate 102 is a sheet metal, the hollow-interior raised regions 104 may be stamped features in the sheet metal. In the described embodiments, the hollow-interior raised regions 104 are integral to the formed coin plate 102. In some embodiments, the hollow-interior raised regions 104 may be planar with a top side of the printed circuit board 106. In some aspects, the hollow-interior raised regions 104 may be in a plane parallel to the top side of the printed circuit board 106 and at a non-planar height which interfaces with a component (such as the heat-generating components 114 described below) attached to the top side of the printed circuit board 106. In other words, the hollow-interior raised regions 104 (and/or alternate flanges) of the formed coin plate 102 may extend outboard of the printed circuit board 106 and may provide a thermal, electrical, and/or mechanical interface within its installation with a component.

In some implementations, the formed coin plate 102 and the hollow-interior raised regions 104 are formed integrally with one another. The formed coin plate 102 is assembled on a bottom side of the printed circuit board 106. In some aspects, the formed coin plate 102 may provide an increased area for conduction to a heat exchanger, may support passive convection cooling, and/or may form a liquid barrier from one side of the formed coin plate to the other such that immersive liquid cooling may be achieved.

In some embodiments, the printed circuit board 106 includes any suitable printed circuit board (PCB). The printed circuit board106 may be any suitable combination of printed circuit boards including a flexible PCB, a rigid PCB, a rigid-flex PCB, a single-sided PCB, a double-sided PCB, and/or a multi-layer PCB. In some forms, the printed circuit board 106 is a multi-layer printed circuit board, while in some forms, the printed circuit board 106 is a single layer of a multi-layer printed circuit board. In some aspects, the printed circuit board 106 may be configured to mount components on a first side and/or a second side. Generally, the printed circuit board 106 includes any suitable combination of materials including aluminum, copper, resin, glass, solder mask, silkscreen, and so forth. In some forms, the through thickness of the printed circuit board 106 has conductivity values between 0.2-10 W/mK and the thickness of the printed circuit board 106 has a thickness between 1-3 mm. By one approach, the printed circuit board 106 has in-plane conductivity values between, for example, 20-100 W/mK or 20-60 W/mK. It is generally contemplated that any alternate suitable conductivity values and/or thicknesses of the printed circuit board106 may be used.

As described above, the printed circuit board 106 includes at least one aperture 108 formed through the printed circuit board 106. In some forms, the apertures 108 register or fit with the hollow-interior raised regions 104. When the formed coin plate 102 is secured to the printed circuit board106, the hollow-interior raised regions 104 are disposed through the apertures 108. The shape and/or size of the apertures 108 is complementary to the shape and/or size of the hollow-interior raised regions 104 such that a snug fit between the two is formed.

In some embodiments, the apparatus 100 includes multiple formed coin plates 102 secured to the printed circuit board 106. In some forms, each formed coin plate 102 includes at least one hollow-interior raised region 104, and each hollow-interior raised region 104 corresponds with an aperture 108 of the printed circuit board 106. Each formed coin plate 102 may be any suitable shape and/or size, and each of the formed coin plates 102 may be uniform with one another and/or may be different compared to one another. In some aspects, the dimensions of each formed coin plate 102 in combination may be the same or similar to the dimensions of the printed circuit board 106. In other words, the side of the printed circuit board 106 adjacent to the multiple formed coin plates 102 corresponds with and is matched to multiple formed coin plates 102 of the same dimensions and none of the referenced bottom side of the printed circuit board 106 is exposed to ambient fluid. In some implementations, the dimensions of each formed coin plate 102 in combination may be less than the dimensions of the printed circuit board 106 such that part of the side of the printed circuit board 106 adjacent to the multiple formed coin plates 102 is directly exposed to ambient fluid and is not entirely matched in shape with the multiple formed coin plates 102. In some aspects, the dimensions of each formed coin plate 102 in combination may be greater than the dimensions of the printed circuit board 106 such that no part of the referenced side of the printed circuit board 106 is exposed to ambient fluid and such that part/parts of the multiple formed coin plates 102 does/do not match with a corresponding part of the printed circuit board 106.

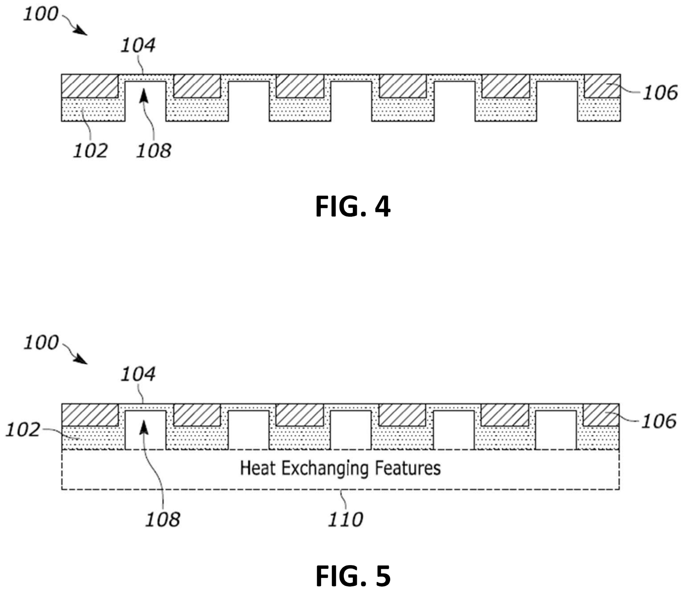

FIG. 4 illustrates an example sectional view of the apparatus 100 through a plane that cuts through 5 raised regions 104 for illustrative purposes. As shown in FIG. 4, the raised regions 104 of the formed coin plate 102 extend through the apertures 108 of the PCB 106. In the example of FIG. 4, the top surfaces of the raised regions 104 are substantially level with the top surface of the PCB 106 and in substantially the same plane as the top surface of the PCB 106. In other implementations, such as when the bottom surfaces of the heat-generating components 114 are higher than the top surface of the PCB 106, the raised regions 104 may extend past the top surface of the PCB 106 to contact the heat-generating components 114.

FIG. 5 shows an example sectional view of the apparatus 100 when apparatus 100 includes suitable heat exchanging features 110 such as pins, fins, and/or other types of protrusions extending from (or recesses extending into) the bottom surface of the formed coin plate 102. FIG. 3 shows the apparatus 100 including heat exchanging features 110 in the form of pins. FIG. 3 shows the heat exchanging features 110 extending outwards from the bottom side of the formed coin plate 102, the bottom side being opposite the top side of the formed coin plate 102 that is in contact with the PCB 106. As shown in FIG. 3, the formed coin plate 102 includes the hollow-interior raised regions 104 extending outwardly from a first side of the formed coin plate 102 and corresponding to coin surface that contact the heat-generating components 114, and heat exchanging features 110 extending outwardly from a second side, opposite the first side, of the formed coin plate 102. In some forms, the heat exchanging features 110 include any combination of heat exchanging pins, heat exchanging fins, and/or alternate suitable features. Generally, the heat exchanging features 110 are configured to spread and dissipate heat from the formed coin plate 102 into ambient fluid (e.g., air). The heat exchanging features 110 generally increase the exposed surface area on the side of the formed coin plate 102 adjacent the ambient fluid, and the increased exposed surface area may increase the rate which heat dissipates from the formed coin plate 102 to the ambient fluid. In some implementations, passive cooling with the heat exchanging features 110 and/or the hollow-interior raised regions 104 has a heat transfer coefficient between 5-25 W/m²K.

In some embodiments, the formed coin plate 102 is mounted with the printed circuit board 106 by any suitable coupling mechanism 112. While the shown embodiment utilizes nuts and bolts as the coupling mechanism 112, any alternative suitable coupling mechanism 112 may be used. The coupling mechanism 112 shown is an example of mechanical coupling, however, in some forms the printed circuit board 106 and the formed coin plate 102 may be laminated/bonded together by any suitable lamination material and/or process. In alternate forms, the formed coin plate 102 and the printed circuit board 106 are spaced apart such that each has a first and second side able to mount components and/or extrude features. In other words, in some implementations, the sides of the formed coin plate 102 and the printed circuit board 106 may be adjacent to one another may not physically touch in areas away from the raised regions 104 and the apertures 108.

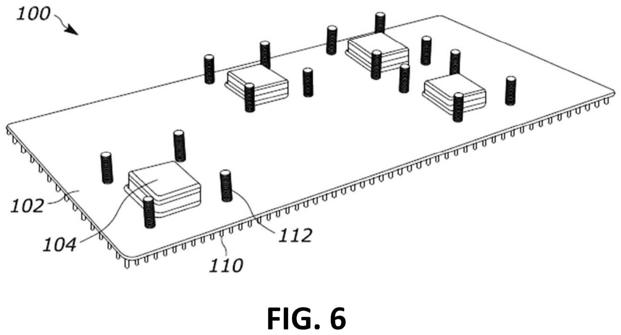

FIG. 6 shows the apparatus 100 without the printed circuit board 106 in accordance with some embodiments. It is generally understood that the printed circuit board 106 is mounted to the formed coin plate 102, and that the present embodiment is provided for illustrative purposes. FIG. 6 shows the formed coin plate 102 with the hollow-interior raised regions 104 extending outwardly from a top side of the formed coin plate 102 and with heat exchanging features 110 extending outwardly from a bottom side of the formed coin plate 102. Further, the coupling mechanism 112 is shown extending outwardly from the formed coin plate 102 in the same direction as the hollow-interior raised regions 104. While four coupling mechanisms 112 per hollow-interior raised region 104 are shown, it is generally contemplated that any alternate suitable number of coupling mechanisms 112 is used. In some forms, the coupling mechanism 112 and the hollow-interior raised regions 104 may extend the same and/or different amounts from the formed coin plate 102 compared to one another.

In some embodiments, there may be additional interface materials between the hollow-interior raised regions 104 of the formed coin plate 102 and the heat-generating components 114 mounted on the printed circuit board 106. In some forms, the additional interface materials may be thermal interface materials with conductivity values between 1-10 W/mK and a thickness between 0.5-5mm. In some aspects, the additional interface materials may be isolation films with conductivity values between 0.1-0.5 W/mK and a thickness less than 0.1mm. In some examples, the additional interface materials may be solder/tin-lead with conductivity values between, for example, 30-400 W/mK or 200-400 W/mK, and a thickness less than 1mm. It is generally understood that any alternate suitable materials with any alternate suitable conductivity values and/or thickness may be used.

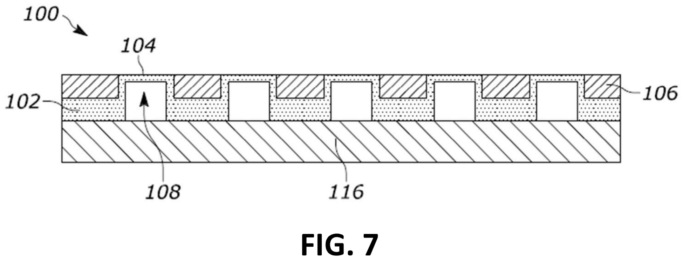

While the shown embodiments include the formed coin plate 102 with hollow-interior raised regions 104, it is generally contemplated that additional heat dissipation features may be included. FIG. 7 shows the apparatus 100 further including a cooling fluid reservoir 116 that is thermally coupled to the formed coin plate 102 in accordance with some embodiments. In some embodiments, the apparatus 100 further includes a cooling fluid reservoir 116 that couples to the formed coin plate 102 generally on the side of the formed coin plate 102 opposite the hollow-interior raised regions 104. The cooling fluid reservoir 116 may include a reservoir to hold any suitable liquid or gas internal to the cooling fluid reservoir 116 for dispersing heat from the formed coin plate 102. In some aspects, the cooling fluid reservoir 116 further disperses heat into the ambient fluid described above. For example, in some forms the cooling fluid reservoir 116 may be a chamber that stores a cooling fluid that is static or circulated with a pump or using another active circulation mechanism. The cooling fluid may include a liquid, a gas, and/or a phase change working fluid that removes heat through the latent heat of vaporization. In another example, in some forms, the cooling fluid reservoir 116 may include heat pipes externally coupled to the formed coin plate 102 that circulate the cooling fluid. Generally, the cooling fluid reservoir 116 may include any suitable liquid cooling feature known in the art. The described apparatus 100 may be used in combination with any suitable additional heat dissipation features, cooling fluid reservoir 116, and/or components, however, it is generally understood that these additional features and/or components are not required for the apparatus 100 to operate effectively.

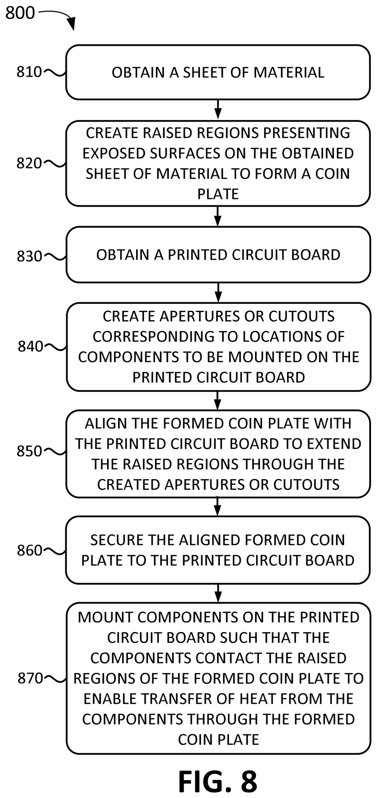

FIG. 8 illustrates a flowchart for a process 800 for forming the apparatus 100. As shown in Fig. 8, process 800 may include obtaining a sheet of material (block 810) and creating raised regions presenting exposed surfaces on the obtained sheet of material to form a coin plate (block 820). For example, a manufacturing apparatus may obtain a sheet of metal and stamp the raised regions 104 into the sheet of metal based on a pattern associated with a corresponding PCB 106. In other embodiments, the raised regions 104 may be obtained through an additive and/or substrative process. For example, the raised regions 104 may be added to the sheet of metal through three-dimensional printing, sputtering, laser sintering, selective laser melting, binder jetting, milling, thread-cutting, selective etching, micromachining, etc.

Process 800 may further include obtaining a printed circuit board (block 830) and creating apertures or cutouts corresponding to locations of the components to be mounted on the printed circuit board (block 840). For example, a manufacturing apparatus may cut apertures or cutouts from the printed circuit board. Process 800 may further include aligning the formed coin plate with the printed circuit board to extend the raised regions through the created apertures or cutouts (block 850) and securing the aligned formed coin plate to the printed circuit board (block 860). For example, the formed coin plate 102 may be aligned with the printed circuit board 106 to extend the raised regions 104 through the apertures 108 (or cutouts) so that the top surfaces of the raised regions 104 are configured to contact the bottom surfaces of the heat-generating components 114 to be mounted on the printed circuit board 106 above the apertures 108 to provide transfer heat paths for heat from the bottom surfaces of the heat-generating components 114 through the formed coin plate 102 to the hollow interior of the raised regions 104. Once aligned, the formed coin plate 102 may be secured to the printed circuit board 106 via coupling mechanisms 112, via bonding or adhesives, and/or via another mechanism.

Process 800 may further include mounting components on the printed circuit board such that the components contact the raised regions of the formed coin plate to enable transfer of heat from the components through the formed coin plate (block 870). The heat-mounting components 114 may then be mounted on the printed circuit board 106 so that the bottom surfaces of the heat-generating components 114 contact the top surfaces of the raised regions 104, enabling the raised regions 104 to function as heat-transfer coins with respect to the heat-generating components 114. In other implementations, the heat-generating components 114 may be mounted to the printed circuit board 106 before the formed coin plate 102 is secured to the printed circuit board 106.

In some implementations, process 800 may additionally include the formation of a dielectric layer on a bottom surface of the formed coin plate 102, the formation of the heat exchanging features 110 on the bottom surface of the formed coin plate 102, the addition of the cooling fluid reservoir 116 to the bottom surface of the formed coin plate 102, and/or the addition of other types of features to improve the heat-transfer properties and/or other types performance-enhancing properties of the formed coin plate 102. For example, the heat exchanging features 110 may be formed on the bottom surface of the formed coin plate 102 after the raised regions 104 are created. In some implementations, the heat exchanging features 110 may be created through an additive manufacturing process, such as by (3D) printing, sputtering, laser sintering, etc., or by bonding a layer of material that includes the heat exchanging features 110 to the bottom side of the formed coin plate 102. In other implementations, the heat exchanging features 110 may be created through a subtractive manufacturing process. For example, the formed coin plate 102 may be formed from a sheet of material with a thickness that corresponds to the thickness of the formed coin plate 102 plus the height of the heat exchanging features 110, and the heat exchanging features 110 may be created by machining or etching away the material between the heat exchanging features 110. A dielectric material may then be deposited on the bottom surface of the formed coin plate 102 through a thin film deposition or coating process.

Further aspects of the disclosure are provided by the subject matter of the following clauses:

A method comprising: creating at least one raised region in a sheet of material to form a coin plate, wherein the at least one raised region includes a hollow interior; creating at least one aperture or cutout in a printed circuit board; aligning the formed coin plate with the printed circuit board to extend the at least one raised region through the at least one aperture or cutout, wherein a surface of the at least one raised region is configured to contact a surface of a heat-generating component, when the heat-generating component is mounted on the printed circuit board, to provide a heat transfer path from the surface of the heat-generating component through the formed coin plate to the hollow interior of the at least one raised region; and securing the aligned formed coin plate to the printed circuit board.

The method of any preceding clause, wherein the sheet of material includes sheet metal.

The method of any preceding clause, further comprising: forming a dielectric layer on a first surface of the formed coined plate, wherein the first surface is opposite a second surface contacting the printed circuit board.

The method of any preceding clause, wherein the at least one raised region comprises a stamped feature in the formed coin plate.

The method of any preceding clause, wherein creating at least one raised region in a sheet of material to form a coin plate comprises at least one of: forming the at least one raised region via an additive material manufacturing process; or forming the at least one raised region via a subtractive material manufacturing process.

The method of any preceding clause, wherein creating the at least one raised region in the sheet of material to form the coin plate includes creating a plurality of raised regions in the sheet of material, wherein creating the at least one aperture or cutout in the printed circuit board includes creating a plurality of apertures or cutouts in the printed circuit board, and wherein aligning the formed coin plate with the printed circuit board to extend the at least one raised region through the at least one aperture or cutout includes aligning the plurality of raised regions with the plurality of apertures or cutouts to extend particular ones of the plurality of raised regions through particular ones of the plurality of apertures or cutouts.

The method of any preceding clause, further comprising: forming a plurality of heat exchanging features on the sheet of material extending away from a first surface of the sheet of material, wherein the first surface is opposite a second surface of the sheet of material contacting the printed circuit board.

The method of any preceding clause, wherein the plurality of heat exchanging features includes at least one of: a plurality of heat exchanging pins; or a plurality of heat exchanging fins.

The method of any preceding clause, further comprising: forming a cooling fluid reservoir that is thermally coupled to the formed coin plate.

The method of any preceding clause, wherein the surface of the at least one raised region is parallel with respect to a surface of the printed circuit board.

An apparatus comprising: a printed circuit board having at least one aperture or cutout; and a formed coin plate having at least one raised region, wherein the at least one raised region includes a hollow interior, wherein the formed coin plate is secured to the printed circuit board, wherein the at least one raised region extends through the at least one aperture or cutout, and wherein a surface of the at least one raised region is configured to contact a surface of a heat-generating component, when the heat-generating component is mounted on the printed circuit board, to provide a heat transfer path from the surface of the heat-generating component through the formed coin plate to the hollow interior of the at least one raised region.

The apparatus of any preceding clause, wherein the formed coin plate includes sheet metal.

The apparatus of any preceding clause, further comprising: a dielectric layer secured to a first surface of the formed coined plate, wherein the first surface is opposite a second surface of the formed coin plate contacting the printed circuit board.

The apparatus of any preceding clause, wherein the at least one raised region comprises a stamped feature in the formed coin plate.

The apparatus of any preceding clause, wherein a height of the at least one raised region extending through the at least one aperture or cutout is based on a height of the surface of the heat-generating component from the printed circuit board, when the heat-generating component is mounted on the printed circuit board.

The apparatus of any preceding clause, wherein the at least one raised region includes a plurality of raised regions, wherein the at least one aperture or cutout includes a plurality of apertures or cutouts, and wherein a particular one of the plurality of raised regions extends through a particular one of the plurality of apertures or cutouts.

The apparatus of any preceding clause, wherein the formed coin plate includes a plurality of heat exchanging features extending away from a first surface of the formed coin plate, wherein the first surface is opposite a second surface of the formed coin plate contacting the printed circuit board.

The apparatus of any preceding clause, wherein the plurality of heat exchanging features includes at least one of: a plurality of heat exchanging pins; or a plurality of heat exchanging fins.

The apparatus of any preceding clause, further comprising: a cooling fluid reservoir that is thermally coupled to the formed coin plate.

The apparatus of any preceding clause, wherein the surface of the at least one raised region is parallel with respect to a surface of the printed circuit board.

A method comprising: providing a planar metallic sheet having at least one hollow-interior raised coin surface formed thereof and extending outwardly thereof; providing a printed circuit board layer having at least one aperture formed therethrough that registers with the at least one hollow-interior raised coin surface; and securing the planar metallic sheet to the printed circuit board layer with the at least one hollow-interior raised coin surface disposed through the at least one aperture to provide a heat transfer path from a heat-generating component that is mounted to the printed circuit board layer to the planar metallic sheet via the at least one hollow-interior raised coin surface.

The method of any preceding clause, wherein the planar metallic sheet includes sheet metal.

The method of any preceding clause, wherein the sheet metal comprises aluminum.

The method of any preceding clause, wherein the at least one hollow-interior raised coin surface comprises a stamped feature in the sheet metal.

The method of any preceding clause, wherein the planar metallic sheet comprises a sheet formed by at least one of: an additive material manufacturing process; and a subtractive material manufacturing process.

The method of any preceding clause, wherein: providing the planar metallic sheet having at least one hollow-interior raised coin surface formed thereof and extending outwardly thereof comprises providing a planar metallic sheet having at least two discrete hollow-interior raised coin surfaces formed thereof and extending outwardly thereof; and providing the printed circuit board layer having at least one aperture formed therethrough that registers with the at least one hollow-interior raised coin surface comprises providing a printed circuit board layer having at least two apertures formed therethrough that each register with a corresponding one of the at least two hollow-interior raised coin surfaces.

The method of any preceding clause, wherein providing the planar metallic sheet having at least one hollow-interior raised coin surface formed thereof and extending outwardly thereof comprises providing a planar metallic sheet having at least one hollow-interior raised coin surface formed thereof and extending outwardly thereof from a first side thereof, and a plurality of heat exchanging features extending outwardly on a second side thereof, which second side is opposite the first side.

The method of any preceding clause, wherein the plurality of heat exchanging features include at least one of: heat exchanging pins; and heat exchanging fins.

The method of any preceding clause, further comprising: providing a liquid cooling feature that thermally couples to the planar metallic sheet.

The method of any preceding clause, wherein: providing the planar metallic sheet having at least one hollow-interior raised coin surface formed thereof and extending outwardly thereof comprises providing a plurality of formed coin plates that each have at least one hollow-interior raised coin surface formed thereof and extending outwardly thereof; providing the printed circuit board layer having at least one aperture formed therethrough that registers with the at least one hollow-interior raised coin surface comprises providing a printed circuit board layer having a plurality of apertures formed therethrough that each register with a corresponding one of the hollow-interior raised coin surfaces; and securing the planar metallic sheet to the printed circuit board layer with the at least one hollow-interior raised coin surface disposed through the at least one aperture comprises securing each of the plurality of formed coin plates to the printed circuit board layer with each of the hollow-interior raised coin surfaces being disposed through a corresponding one of the plurality of apertures.

An apparatus comprising: a planar metallic sheet having at least one hollow-interior raised coin surface formed thereof and extending outwardly thereof; and a printed circuit board layer having at least one aperture formed therethrough that registers with the at least one hollow-interior raised coin surface, wherein the planar metallic sheet is secured to the printed circuit board layer with the at least one hollow-interior raised coin surface disposed through the at least one aperture to provide a heat transfer path from a heat-generating component that is mounted to the printed circuit board layer to the planar metallic sheet via the at least one hollow-interior raised coin surface.

The apparatus of any preceding clause, wherein the planar metallic sheet includes sheet metal.

The apparatus of any preceding clause, wherein the sheet metal comprises aluminum.

The apparatus of any preceding clause, wherein the at least one hollow-interior raised coin surface comprises a stamped feature in the sheet metal.

The apparatus of any preceding clause, wherein the planar metallic sheet comprises a sheet formed by at least one of: an additive material manufacturing process; and a subtractive material manufacturing process.

The apparatus of any preceding clause, wherein: the planar metallic sheet has at least two discrete hollow-interior raised coin surfaces formed thereof and extending outwardly thereof; and the printed circuit board layer has at least two apertures formed therethrough that each register with a corresponding one of the at least two hollow-interior raised coin surfaces.

The apparatus of any preceding clause, wherein providing the planar metallic sheet has a plurality of heat exchanging features extending outwardly therefrom.

The apparatus of any preceding clause, wherein the plurality of heat exchanging features include at least one of: heat exchanging pins; and heat exchanging fins.

The apparatus of any preceding clause, further comprising: a liquid cooling feature that is thermally coupled to the planar metallic sheet.

The apparatus of any preceding clause, further comprising: a plurality of planar metallic sheets that each have at least one hollow-interior raised coin surface formed thereof and extending outwardly thereof; wherein the printed circuit board layer has a plurality of apertures formed therethrough that each register with a corresponding one of the hollow-interior raised coin surfaces, and wherein each of the plurality of planar metallic sheets is secured to the printed circuit board layer with each of the hollow-interior raised coin surfaces being disposed through a corresponding one of the plurality of apertures.

## Claims

1. A method comprising:
creating at least one raised region (104) in a sheet of material to form a coin plate (102), wherein the at least one raised region (104) includes a hollow interior;
creating at least one aperture (108) or cutout in a printed circuit board;
aligning the formed coin plate (102) with the printed circuit board to extend the at least one raised region (104) through the at least one aperture (108) or cutout, wherein a surface of the at least one raised region (104) is configured to contact a surface of a heat-generating component (114), when the heat-generating component (114) is mounted on the printed circuit board (106), to provide a heat transfer path from the surface of the heat-generating component (114) through the formed coin plate (102) to the hollow interior of the at least one raised region (104); and
securing the aligned formed coin plate (102) to the printed circuit board (106).

2. The method of claim 1, further comprising:
forming a dielectric layer on a first surface of the formed coined plate, wherein the first surface is opposite a second surface contacting the printed circuit board (106).

3. The method of any preceding claim, wherein the at least one raised region (104) comprises a stamped feature in the formed coin plate (102).

4. The method of any preceding claim, wherein creating at least one raised region (104) in a sheet of material to form a coin plate (102) comprises at least one of:
forming the at least one raised region (104) via an additive material manufacturing process; or
forming the at least one raised region (104) via a subtractive material manufacturing process.

5. The method of any preceding claim, wherein creating the at least one raised region (104) in the sheet of material to form the coin plate (102) includes creating a plurality of raised regions (104) in the sheet of material, wherein creating the at least one aperture (108) or cutout in the printed circuit board (106) includes creating a plurality of apertures (108) or cutouts in the printed circuit board (106), and wherein aligning the formed coin plate (102) with the printed circuit board (106) to extend the at least one raised region (104) through the at least one aperture (108) or cutout includes aligning the plurality of raised regions (104) with the plurality of apertures (108) or cutouts to extend particular ones of the plurality of raised regions (104) through particular ones of the plurality of apertures (108) or cutouts.

6. The method of any preceding claim, further comprising:
forming a plurality of heat exchanging features (110) on the sheet of material extending away from a first surface of the sheet of material, wherein the first surface is opposite a second surface of the sheet of material contacting the printed circuit board (106), wherein the plurality of heat exchanging features include at least one of:
a plurality of heat exchanging pins; or
a plurality of heat exchanging fins.

7. The method of any preceding claim, further comprising:
forming a cooling fluid reservoir that is thermally coupled to the formed coin plate (102).

8. An apparatus comprising:
a printed circuit board (106) having at least one aperture (108) or cutout; and
a formed coin plate (102) having at least one raised region (104),
wherein the at least one raised region (104) includes a hollow interior,
wherein the formed coin plate (102) is secured to the printed circuit board (106),
wherein the at least one raised region (104) extends through the at least one aperture (108) or cutout, and
wherein a surface of the at least one raised region (104) is configured to contact a surface of a heat-generating component (114), when the heat-generating component (114) is mounted on the printed circuit board (106), to provide a heat transfer path from the surface of the heat-generating component (114) through the formed coin plate (102) to the hollow interior of the at least one raised region (104).

9. The apparatus of claim 8, further comprising:
a dielectric layer secured to a first surface of the formed coined plate, wherein the first surface is opposite a second surface of the formed coin plate (102) contacting the printed circuit board (106).

10. The apparatus of any of claims 8-9, wherein the at least one raised region (104) comprises a stamped feature in the formed coin plate (102).

11. The apparatus of any of claims 8-10, wherein a height of the at least one raised region (104) extending through the at least one aperture (108) or cutout is based on a height of the surface of the heat-generating component (114) from the printed circuit board (106), when the heat-generating component (114) is mounted on the printed circuit board (106).

12. The apparatus of any of claims 8-11, wherein the at least one raised region (104) includes a plurality of raised regions (104), wherein the at least one aperture (108) or cutout includes a plurality of apertures (108) or cutouts, and wherein a particular one of the plurality of raised regions (104) extends through a particular one of the plurality of apertures (108) or cutouts.

13. The apparatus of any of claims 8-12, wherein the formed coin plate (102) includes a plurality of heat exchanging features (110) extending away from a first surface of the formed coin plate (102), wherein the first surface is opposite a second surface of the formed coin plate (102) contacting the printed circuit board.

14. The apparatus of claim 13, wherein the plurality of heat exchanging features (110) include at least one of:
a plurality of heat exchanging pins; or
a plurality of heat exchanging fins.

15. The apparatus of any of claims 8-14, further comprising:
a cooling fluid reservoir that is thermally coupled to the formed coin plate (102).
